# EUROPEAN PATENT APPLICATION

(11) **EP 4 593 072 A1**
(43) Date of publication of application: **30.07.2025**
(21) Application number: 25151483.2
(22) Date of filing: 13.01.2025
(51) Int. Cl.: H01L 21/768, H01L 23/485, H01L 23/528

(54) **INTEGRATED CIRCUIT DEVICE INCLUDING A GATE LINE**

(30) Priority: 24.01.2024 KR 20240011184
(71) Applicant: Samsung Electronics Co., Ltd., Suwon-si, Gyeonggi-do 16677 (KR)
(72) Inventor: KIM, Seonbae, 16677 Suwon-si, Gyeonggi-do (KR); PARK, Hyunho, 16677 Suwon-si, Gyeonggi-do (KR); SHIN, Heonjong, 16677 Suwon-si, Gyeonggi-do (KR); LEE, Doohyun, 16677 Suwon-si, Gyeonggi-do (KR); LEE, Jaegyeong, 16677 Suwon-si, Gyeonggi-do (KR)
(74) Representative: Kuhnen & Wacker Patent- und Rechtsanwaltsbüro PartG mbB

(57) **Abstract**

An integrated circuit device (100) includes: a fin-type active area (F1) extending in a first horizontal direction (X) on a substrate; a gate line (160) extending in a second horizontal direction (Y) crossing the first horizontal direction (X) on the fin-type active area (F1); a source/drain area (130) arranged on the fin-type active area (F1); a gate dielectric layer (152) disposed on the gate line (160); a source/drain contact (CA) arranged on the source/drain area (130); a via contact (VA) integrally connected to the source/drain contact (CA) and protruding in a vertical direction (Z); a gate contact plug (CB) integrally connected to the gate line (160) and protruding in the vertical direction (Z); a first wiring layer electrically connected to the via contact (VA) and the gate contact plug (CB); and a via rail (VAR) connected to the first wiring layer, and extending in the first horizontal direction (X) at a vertical level that is lower than a vertical level of the first wiring layer.

## Description

### TECHNICAL FIELD

The present inventive concept relates to an integrated circuit device, and more particularly, to an integrated circuit device including a gate line.

### DISCUSSION OF THE RELATED ART

Due to the development of electronic technology, down-scaling of integrated circuit devices is rapidly progressing, and accordingly, the line width and pitch of gate lines, which are included in the integrated circuit devices, and contact structures connected to the gate lines are also becoming finer. Accordingly, an integrated circuit device capable of improving electrical characteristics and reliability is currently under development.

### SUMMARY

According to an embodiment of the present inventive concept, an integrated circuit device includes: a fin-type active area extending in a first horizontal direction on a substrate; a gate line extending in a second horizontal direction crossing the first horizontal direction on the fin-type active area and the substrate; a source/drain area arranged on the fin-type active area; a gate dielectric layer disposed on a lower surface and sidewalls of the gate line; a source/drain contact arranged on the source/drain area to be in contact with the source/drain area; a via contact integrally connected to the source/drain contact and protruding in a vertical direction; a gate contact plug integrally connected to the gate line and protruding in the vertical direction; a first wiring layer electrically connected to the via contact and the gate contact plug, and extending in the first horizontal direction; and a via rail connected to the first wiring layer, and extending in the first horizontal direction at a vertical level that is lower than a vertical level of the first wiring layer.

According to an embodiment of the present inventive concept, an integrated circuit device includes: a fin-type active area extending in a first horizontal direction on a substrate; a gate line extending in a second horizontal direction crossing the first horizontal direction on the fin-type active area and the substrate; a source/drain area arranged on the fin-type active area; a gate dielectric layer disposed on a lower surface and sidewalls of the gate line; a source/drain contact arranged on the source/drain area to be in contact with the source/drain area; a via contact integrally connected to the source/drain contact and configured to protrude in a vertical direction; a gate contact plug integrally connected to the gate line and protruding in the vertical direction; a first wiring layer electrically connected to the via contact and the gate contact plug, and extending in the first horizontal direction; and a via rail extending in the first horizontal direction and in contact with the first wiring layer, wherein the via rail is in contact with sidewalls of the via contact.

According to an embodiment of the present inventive concept, an integrated circuit device includes: a fin-type active area extending in a first horizontal direction on a substrate; a gate line extending in a second horizontal direction crossing the first horizontal direction on the fin-type active area and the substrate; a source/drain area arranged on the fin-type active area; a gate dielectric layer disposed on a lower surface and sidewalls of the gate line; a source/drain contact arranged on the source/drain area to be in contact with the source/drain area; a via contact integrally connected to the source/drain contact and protruding in a vertical direction; a gate contact plug integrally connected to the gate line and protruding in the vertical direction; a first wiring layer electrically connected to the via contact and the gate contact plug, and extending in the first horizontal direction; a via contact extension portion arranged between the first wiring layer and the via contact; a gate contact plug extension portion arranged between the first wiring layer and the gate contact plug; a first spacer configured to conformally cover an upper surface of the gate line, an upper surface of the source/drain contact, sidewalls of the gate contact plug, and sidewalls of the via contact; a second spacer configured to cover the first spacer, and including a material of different etching selectivity from the first spacer; and a via rail extending in the first horizontal direction and in contact with the first wiring layer, wherein the via rail is in contact with sidewalls of the via contact and sidewalls of the via contact extension portion.

### BRIEF DESCRIPTION OF THE DRAWINGS

The above and other aspects of the present inventive concept will become more apparent by describing in detail embodiments thereof, with reference to the accompanying drawings, in which:
FIG. 1 is a plan layout diagram of an integrated circuit device according to an embodiment of the present inventive concept;
FIG. 2A is a cross-sectional view taken along line X1-X1' in FIG. 1;
FIG. 2B is a cross-sectional view taken along line X2-X2' in FIG. 1;
FIG. 2C is a cross-sectional view taken along line Y1-Y1' in FIG. 1;
FIG. 2D is a cross-sectional view taken along line Y2-Y2' in FIG. 1; and

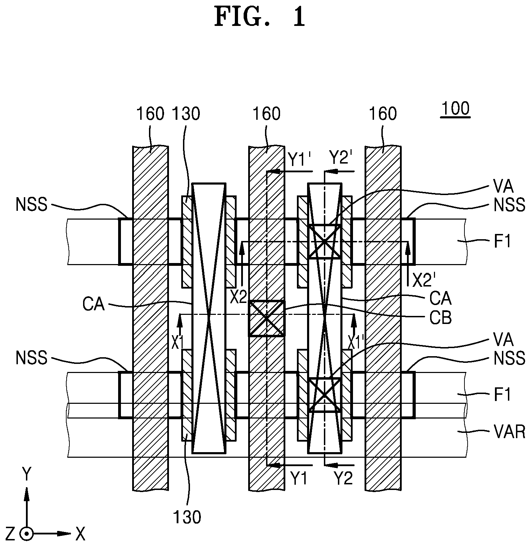

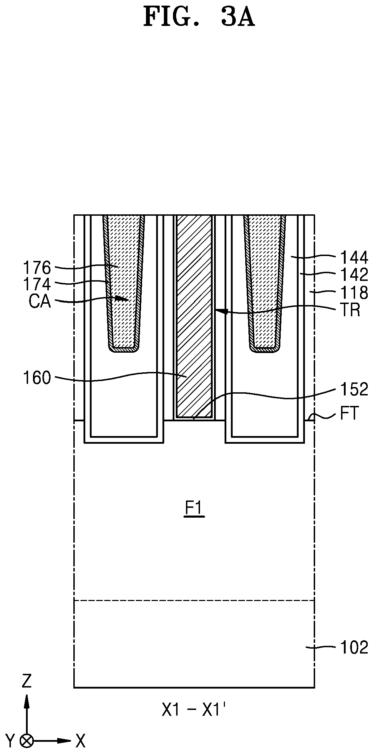

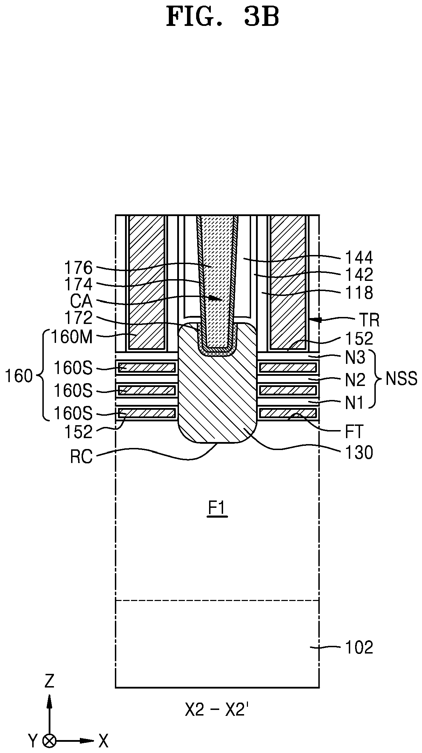

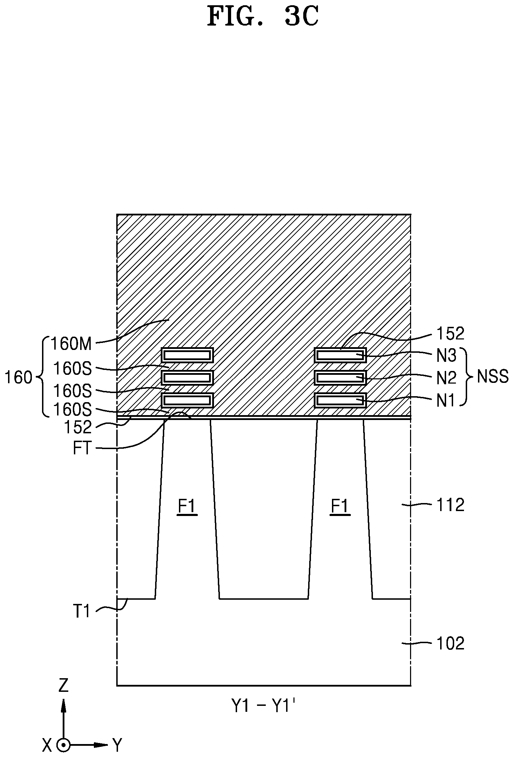

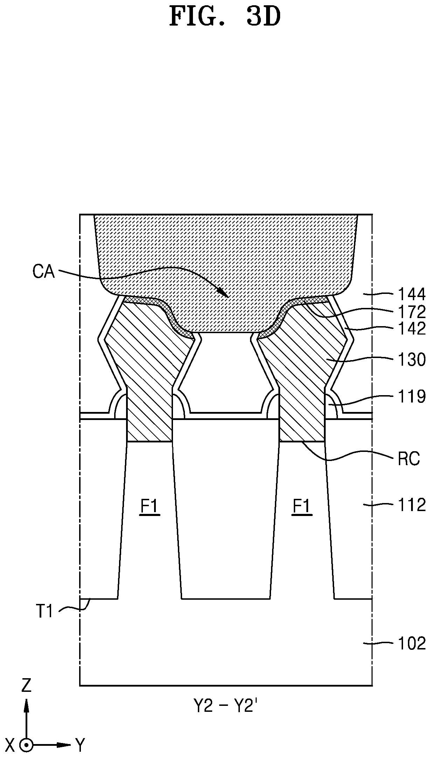

FIGS. 3A through 9D are cross-sectional views for describing a manufacturing method of an integrated circuit device, according to embodiments of the present inventive concept, wherein: FIGS. 3A, 4A, 5A, 6A, 7A, 8A, and 9A are cross-sectional views of a portion corresponding to a cross-sectional view taken along line X1-X1' in FIG. 1 according to a process sequence; FIGS. 3B, 4B, 5B, 6B, 7B, 8B, and 9B are cross-sectional views of a portion corresponding to a cross-sectional view taken along line X2-X2' in FIG. 1 according to a process sequence; FIGS. 3C, 4C, 5C, 6C, 7C, 8C, and 9C are cross-sectional views of a portion corresponding to a cross-sectional view taken along line Y1-Y1' in FIG. 1 according to a process sequence; and FIGS. 3D, 4D, 5D, 6D, 7D, 8D, and 9D are cross-sectional views of a portion corresponding to a cross-sectional view taken along line Y2-Y2' in FIG. 1 according to a process sequence.

### DETAILED DESCRIPTION OF THE EMBODIMENTS

Hereinafter, embodiments of the inventive concept are described in detail with reference to the accompanying drawings. Identical reference numerals are used for the same constituent elements in the drawings, and duplicate descriptions thereof are omitted.
FIG. 1 is a plan layout diagram of an integrated circuit device 100 according to an embodiment.

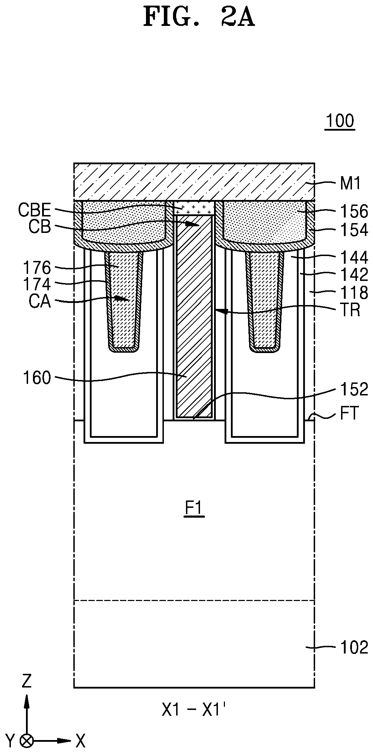

FIG. 2A is a cross-sectional view taken along line X1-X1' in FIG. 1.

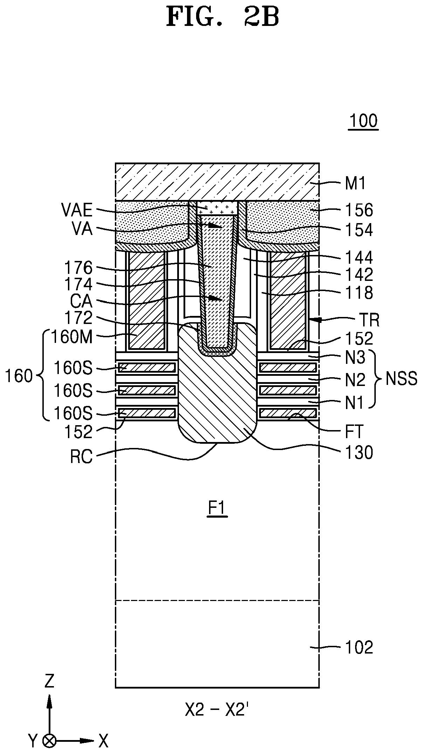

FIG. 2B is a cross-sectional view taken along line X2-X2' in FIG. 1.

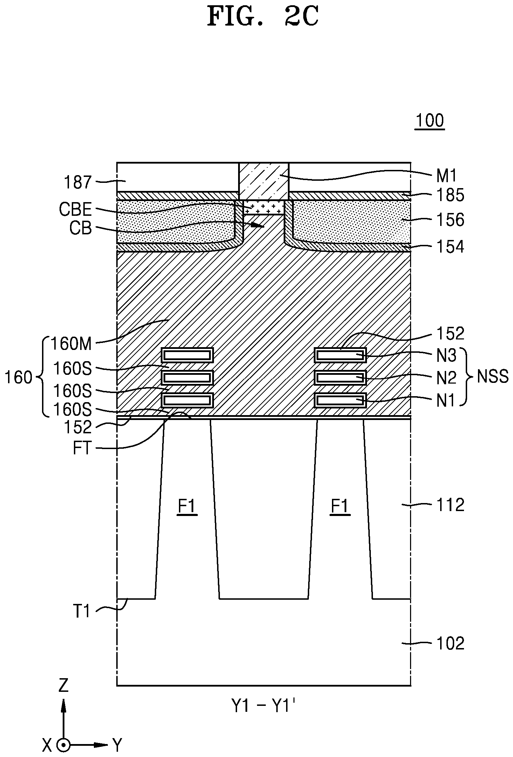

FIG. 2C is a cross-sectional view taken along line Y1-Y1' in FIG. 1.

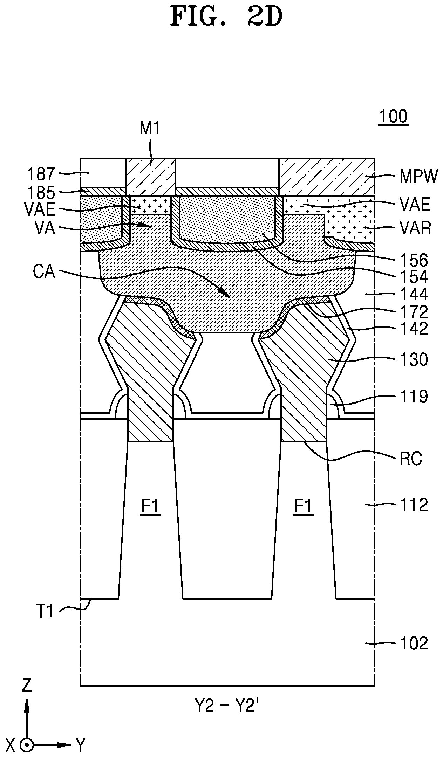

FIG. 2D is a cross-sectional view taken along line Y2-Y2' in FIG. 1.

The integrated circuit device 100 including a field-effect transistor TR having an active area including a nanowire or having a nanosheet shape, and a gate-all-around structure including a gate surrounding the active area is described with reference to FIGS. 1 and 2A through 2D. However, the integrated circuit device 100 of the present inventive concept is not limited thereto, and may also include a transistor of a fin field effect transistor (FINFET) structure.

Referring to FIGS. 1, 2A through 2D, the integrated circuit device 100 may include a plurality of fin-type active areas F1 protruding from a substrate 102 and extending in the first horizontal direction (X direction), and a plurality of nanosheet stacks NSS disposed on a fin upper surface FT in a fin-type active area F1 at positions spaced apart from the plurality of fin-type active areas F1 in the vertical direction (Z direction). The term "nanosheet" used in the present inventive concept may be referred to as a conductive structure having a cross-section substantially perpendicular to a direction in which a current flows. The nanosheet should be understood to include nanowires.

The substrate 102 may include a trench T1 defining the plurality of fin-type active areas F1, and the trench T1 may be filled with a device separation layer 112. The substrate 102 may include a semiconductor such as Si and Ge, or a compound semiconductor such as SiGe, SiC, GaAs, InAs, InGaAs, and InP. The terms SiGe, SiC, GaAs, InAs, InGaAs, and InP used in the present inventive concept may be referred to as materials including elements included in each term, but might not be referred to as chemical formulas representing a stoichiometric relationship. The substrate 102 may include a conductive area, for example, a well doped with impurities, or a structure doped with impurities. For example, the device separation (isolation) layer 112 may include an oxide layer, a nitride layer, or a combination thereof.

A plurality of gate lines 160 may be respectively arranged on the plurality of fin-type active areas F1. Each of the plurality of gate lines 160 may extend in the second horizontal direction (Y direction) crossing the first horizontal direction (X direction).

The plurality of nanosheet stacks NSS may be arranged on the fin upper surface FT of each of the plurality of fin-type active areas F1 in areas where the plurality of fin-type active areas F1 and the plurality of gate lines 160 cross each other. The plurality of nanosheet stacks NSS may include at least one nanosheet. Each of the plurality of nanosheet stacks NSS may include a first nanosheet N1, a second nanosheet N2, and a third nanosheet N3, which overlap each other on the fin-type active area F1 in the vertical direction (Z direction). Vertical distances (Z direction distance) of the first nanosheet N1, the second nanosheet N2, and the third nanosheet N3 from the fin upper surface FT of the fin-type active area F1 may be different from each other. Each of the plurality of gate lines 160 may surround the first nanosheet N1, the second nanosheet N2, and the third nanosheet N3, which are included in the nanosheet stack NSS and overlap each other in the vertical direction (Z direction).

In FIG. 1, the case in which a planar shape of the nanosheet stack NSS has a roughly rectangular shape is illustrated, but the present inventive concept is not limited thereto. The nanosheet stack NSS may have various planar shapes according to a planar shape of each of the fin-type active area F1 and each of the plurality of gate lines 160. In the present embodiment, the intersection between the plurality of nanosheet stacks NSS and the plurality of gate lines 160 may be arranged on one fin-type active area F1, and a configuration is illustrated in which the plurality of nanosheet stacks NSS are arranged on one fin-type active area F1 in a line in the first horizontal direction (X direction). However, the number of the nanosheet stacks NSS and the gate lines 160, which are arranged on one fin-type active area F1 might not be particularly limited. In embodiments of the present inventive concept, the case where each of the plurality of nanosheet stacks NSS includes three nanosheets is illustrated, but the present inventive concept is not limited thereto. For example, the nanosheet stack NSS may include at least one nanosheet, and the number of nanosheets constituting the nanosheet stack NSS is not particularly limited.

Each of the first nanosheet N1, the second nanosheet N2, and the third nanosheet N3, which are included in the nanosheet stack NSS, may have a channel area. In embodiments of the present inventive concept, each of the first nanosheet N1, the second nanosheet N2, and the third nanosheet N3, which are included in the nanosheet stack NSS, may include a Si layer, a SiGe layer, or a combination thereof.

In embodiments of the present inventive concept, each of the first nanosheet N1, the second nanosheet N2, and the third nanosheet N3 may have a thickness in a range of about 4 nm to about 6 nm, but the present inventive concept is not limited thereto. In this case, the thickness of each of the first nanosheet N1, the second nanosheet N2, and the third nanosheet N3 may be a size in the vertical direction (Z direction). In embodiments of the present inventive concept, the first nanosheet N1, the second nanosheet N2, and the third nanosheet N3 may have substantially the same thickness as each other in the vertical direction (Z direction). In embodiments of the present inventive concept, at least some of the first nanosheet N1, the second nanosheet N2, and the third nanosheet N3 may have different thicknesses from each other in the vertical direction (Z direction).

The first nanosheet N1, the second nanosheet N2, and the third nanosheet N3, which are included in one nanosheet stack NSS, may have the same size or similar sizes in the first horizontal direction (X direction). In embodiments of the present inventive concept, at least some of the first nanosheet N1, the second nanosheet N2, and the third nanosheet N3, which are included in one nanosheet stack NSS, may have different sizes from each other in the first horizontal direction (X direction).

Each of the plurality of gate lines 160 may include a main gate portion 160M and a plurality of sub-gate portions 160S. The main gate portion 160M may cover an upper surface of the nanosheet stack NSS, and extend in the second horizontal direction (Y direction). The plurality of sub-gate portions 160S may be connected to the main gate portion 160M in one body, and each of the plurality of sub-gate portions 160S may be arranged between each of the first nanosheet N1, the second nanosheet N2, and the third nanosheet N3, and between the first nanosheet N1 and the fin-type active area F1. In the vertical direction (Z direction), the thickness of each of the plurality of sub-gate portions 160S may be less than the thickness of the main gate portion 160M.

A plurality of recesses RC may be formed on the fin-type active area F1. A vertical level of the lowermost surface of each of the plurality of recesses RC may be lower than a vertical level of the fin upper surface FT. The term of "vertical level" used in the present inventive concept may be a distance from a main surface 102M of the substrate 102 in the vertical direction (Z direction).

A plurality of source/drain areas 130 may be respectively arranged in the plurality of recesses RC. Each of the plurality of source/drain areas 130 may be arranged at a position adjacent to at least one gate line 160 among the plurality of gate lines 160. Each of the plurality of source/drain areas 130 may have surfaces facing the first nanosheet N1, the second nanosheet N2, and the third nanosheet N3, which are included in the adjacent nanosheet stack NSS. Each of the plurality of source/drain areas 130 may have surfaces in contact with the first nanosheet N1, the second nanosheet N2, and the third nanosheet N3, which are included in the adjacent nanosheet stack NSS.

Each of the plurality of gate lines 160 may include, for example, a metal, metal nitride, metal carbide, or a combination thereof. For example, the metal may include Mo, Ru, Cu, or W. The metal nitride may include, for example, TiN, TaN, TiAlN, or a combination thereof. The metal carbide may include, for example, TiAlC. However, the materials constituting the plurality of gate lines 160 are not limited to the examples described above.

A gate dielectric layer 152 may be arranged between the nanosheet stack NSS and the gate line 160. In embodiments of the present inventive concept, the gate dielectric layer 152 may have a stacked structure of an interface dielectric layer and a high dielectric layer. The interface dielectric layer may include a low dielectric material layer having a dielectric constant of about 9 or less, for example, a silicon oxide layer, a silicon oxynitride layer, or a combination thereof. In embodiments of the present inventive concept, the interface dielectric layer may be omitted. The high-k layer may include a material having a dielectric constant greater than a dielectric constant of the silicon oxide layer. For example, the high-k layer may have a dielectric constant of about 10 to about 25. The high-k layer may include, for example, hafnium oxide, but the present inventive concept is not limited thereto.

The plurality of fin-type active areas F1 on the substrate 102 and a plurality of insulating spacers 118 on the nanosheet stack NSS may extend in the second horizontal direction (Y direction). Both sidewalls of the gate line 160 may be covered with a pair of insulating spacers 118. The insulating spacer 118 may cover both sidewalls of the main gate portion 160M on an upper surface of the plurality of nanosheet stacks NSS. The insulating spacer 118 may be spaced apart from the gate line 160 with the gate dielectric layer 152 therebetween. The insulating spacer 118 may include, for example, silicon nitride, silicon oxide, SiCN, SiBN, SiON, SiOCN, SiBCN, SiOC, or a combination thereof. The terms SiCN, SiBN, SiON, SiOCN, SiBCN, and SiOC used in the present inventive concept may be referred to as materials including elements included in each term, but might not be referred to as chemical formulas representing a stoichiometric relationship.

A pair of insulating spacers 118 covering both sidewalls of the gate line 160 may extend in the second horizontal direction (Y direction). The gate line 160 may cover the fin-type active area F1 and the nanosheet stack NSS, and extend in the second horizontal direction (Y direction). The gate dielectric layer 152 may be in contact with the surface of the fin-type active area F1 and the surface of each of the first nanosheet N1, the second nanosheet N2, and the third nanosheet N3, which are included in the nanosheet stack NSS, and may be in contact with the lower surface and both sidewalls of the gate line 160. The gate dielectric layer 152 may extend in the second horizontal direction (Y direction).

Both sidewalls of each of the plurality of sub-gate portions 160S may be spaced apart from the source/drain area 130 with the gate dielectric layer 152 and the insulating spacer 118 therebetween. The gate dielectric layer 152 may be arranged between the sub-gate portion 160S included in the gate line 160 and each of the first nanosheet N1, the second nanosheet N2, and the third nanosheet N3, and between the sub-gate portion 160S included in the gate line 160 and the source/drain area 130.

The plurality of nanosheet stacks NSS may be arranged on the fin upper surface FT of each of the plurality of fin-type active areas F1 in areas where the plurality of fin-type active areas F1 and the plurality of gate lines 160 cross each other, and may be disposed on the fin upper surface FT of the fin-type active area F1 at a position such that the plurality of nanosheet stacks NSS are spaced apart from the fin-type active area F1. A plurality of field effect transistors TR may be formed in areas where the plurality of fin-type active areas F1 and the plurality of gate lines 160 cross each other on the substrate 102.

A plurality of gate contact plugs CB may be arranged on the plurality of gate lines 160. The gate contact plug CB may have a structure integrally connected to the gate line 160. The gate contact plug CB may be integrally formed with the main gate portion 160M, and may protrude from the upper surface of the main gate portion 160M in the vertical direction (Z direction). Accordingly, the gate contact plug CB and the main gate portion 160M may have a single structure having no interface therebetween. In this case, the sidewall portion of the gate contact plug CB connected to the main gate portion 160M may have a round shape.

In embodiments of the present inventive concept, the plurality of gate lines 160 and the plurality of gate contact plugs CB may include the same material. For example, each of the plurality of gate lines 160 and the plurality of gate contact plugs CB may include a metal, metal nitride, metal carbide, or a combination thereof. The metal may include, for example, Mo, Ru, Cu, or W. The metal nitride may include, for example, TiN, TaN, TiAlN, or a combination thereof. The metal carbide may include, for example, TiAlC. However, the materials constituting the plurality of gate lines 160 are not limited to the examples described above.

A gate contact plug extension portion CBE may be arranged on the gate contact plug CB. The gate contact plug extension portion CBE may electrically connect the gate contact plug CB to an upper wiring layer M1. In this case, the gate contact plug extension portion CBE may include the same material as a source/drain contact CA and a via contact VA to be described below. However, the present inventive concept is not limited thereto, and the gate contact plug extension portion CBE may include a material different from a material of the source/drain contact CA and the via contact VA. For example, the gate contact plug extension portion CBE may include the same material as the gate line 160 and the gate contact plug CB.

A metal silicide layer 172 may be formed on an upper surface of each of the plurality of source/drain areas 130. For example, the metal silicide layer 172 may include a metal including Ti, W, Ru, Nb, Mo, Hf, Ni, Co, Pt, Yb, Tb, Dy, Er, or Pd. For example, the metal silicide layer 172 may include titanium silicide, but the present inventive concept is not limited thereto.

An insulating liner 142 and an inter-gate insulating layer 144 may be sequentially arranged on the plurality of source/drain areas 130 and a plurality of metal silicide layers 172. The insulating liner 142 and the inter-gate insulating layer 144 may constitute an insulating structure. The insulating spacer 118 and the plurality of source/drain areas 130 may be covered with the insulating liner 142. In embodiments of the present inventive concept, the insulating liner 142 may include silicon nitride (SiN), SiCN, SiBN, SiON, SiOCN, SiBCN, or a combination thereof, but the present inventive concept is not limited thereto. The inter-gate insulating layer 144 may include a silicon oxide layer, but the present inventive concept is not limited thereto. In embodiments of the present inventive concept, the insulating liner 142 may be omitted. When the insulating liner 142 is omitted, the inter-gate insulating layer 144 may be in contact with the plurality of source/drain areas 130.

A plurality of source/drain contacts CA may be respectively arranged on the plurality of source/drain areas 130. Each of the plurality of source/drain contacts CA may penetrate an insulating structure including the inter-gate insulating layer 144 and the insulating liner 142 in the vertical direction (Z direction), and may be in contact with the metal silicide layer 172. Each of the plurality of source/drain contacts CA may be configured to be electrically connected to the source/drain area 130 via the metal silicide layer 172. The plurality of source/drain contacts CA may be spaced apart from the main gate portion 160M with the insulating spacer 118 therebetween in the first horizontal direction (X direction).

A plurality of via contacts VA may be respectively arranged on the plurality of source/drain contacts CA. The plurality of via contacts VA may have a structure in which the plurality of via contacts VA are respectively and integrally connected to the plurality of source/drain contacts CA. The source/drain contact CA and the via contact VA, which are respectively and integrally connected to each other, may constitute a source/drain contact structure. The source/drain contact structure may include a conductive barrier layer 174 and a contact plug 176. The conductive barrier layer 174 may cover a lower surface and both sidewalls of the contact plug 176 in the first horizontal direction (X direction). The conductive barrier layer 174 and the contact plug 176 may include a lower portion constituting the source/drain contact CA and an upper portion constituting the via contact VA, respectively. The lower portion and the upper portion of each of the conductive barrier layer 174 and the contact plug 176 may be an integrally connected structure. The conductive barrier layer 174 may be arranged between the metal silicide layer 172 and the contact plug 176. For example, the conductive barrier layer 174 may include a surface in contact with the metal silicide layer 172, and a surface in contact with the contact plug 176. In embodiments of the present inventive concept, the conductive barrier layer 174 may also be omitted.

The via contact VA may have a structure in which the via contact VA is integrally connected to the source/drain contact CA. The via contact VA may be integrally formed with the source/drain contact CA, and may protrude from the upper surface of the source/drain contact CA in a vertical direction (Z direction). Accordingly, the via contact VA and the source/drain contact CA may be a single structure having no interface therebetween. In this case, a sidewall portion of the via contact VA connected to the source/drain contact CA may have a round shape.

The plurality of source/drain contacts CA and the plurality of via contacts VA may include the same material as each other. For example, the conductive barrier layer 174 that is formed on the plurality of source/drain contacts CA and the plurality of via contacts VA may include a metal or metal nitride. For example, the conductive barrier layer 174 may include Ti, Ta, W, TiN, TaN, WN, WCN, TiSiN, TaSiN, WSiN, or a combination thereof, but is not limited thereto. The contact plug 176 constituting the plurality of source/drain contacts CA and the plurality of via contacts VA may include a metal of molybdenum (Mo), copper (Cu), tungsten (W), cobalt (Co), ruthenium (Ru), manganese (Mn), titanium (Ti), tantalum (Ta), aluminum (Al), and a combination thereof.

A via contact extension portion VAE may be arranged on the via contact VA. The via contact extension portion VAE may electrically connect the via contact VA to the upper wiring layer M1. In this case, the via contact extension portion VAE may include the same material as the source/drain contact CA and the via contact VA. However, the present inventive concept is not limited thereto, and the via contact extension portion VAE may include a material different from the material of the source/drain contact CA and the via contact VA.

An upper surface of the plurality of via contacts VA and an upper surface of the plurality of gate contact plugs CB may be at substantially the same vertical level as each other. In addition, an upper surface of the gate contact plug extension portion CBE and an upper surface of the via contact extension portion VAE may be at substantially the same vertical level as each other. In this case, the gate contact plug extension portion CBE and the via contact extension portion VAE may have a thickness of about 5 nm in the vertical direction (Z direction).

A first spacer 154 may conformally cover the gate line 160, the source/drain contact CA, the gate contact plug CB, the via contact VA, the gate contact plug extension portion CBE, and the via contact extension portion VAE. For example, the first spacer 154 may cover an upper surface of the gate line 160, in which the gate contact plug CB is not arranged, and the upper surface of the source/drain contact CA, in which the via contact VA is not arranged. In addition, the first spacer 154 may cover sidewalls of each of the gate contact plug CB, the via contact VA, the gate contact plug extension portion CBE, and the via contact extension portion VAE.

A second spacer 156 may be arranged on the first spacer 154. In this case, the first spacer 154, the second spacer 156, the gate contact plug extension portion CBE, and the upper surface of the via contact extension portion VAE may be substantially coplanar with each other. In embodiments of the present inventive concept, the second spacer 156 may include a material having an etching selectivity different from selectivity of the first spacer 154. For example, the first spacer 154 may include a SiOC material, and the second spacer 156 may include silicon nitride.

A via rail VAR may extend in the first horizontal direction (X direction). For example, the via rail VAR may extend lengthwise in the first horizontal direction (X direction). The via rail VAR may be arranged to be in contact with the via contact VA and the via contact extension portion VAE. One of sidewalls of the via rail VAR in the second horizontal direction (Y direction) may be in contact with the sidewall of the via contact VA. In addition, the via rail VAR and the via contact extension portion VAE may be arranged to partially overlap each other in the second horizontal direction (Y direction). In this case, the sidewall of the via rail VAR in the second horizontal direction (Y direction) may have a round shape. In addition, the sidewall of the via contact VA in the second horizontal direction (Y direction) may have a round shape. In this case, the via rail VAR may include the same material as the source/drain contact CA and the via contact VA. However, the present inventive concept is not limited thereto, and the via contact extension portion VAE may include a material different from the material of the source/drain contact CA and the via contact VA. In an embodiment of the present inventive concept, a lower surface of the via rail be rounded.

The integrated circuit device 100 of the present inventive concept may include the gate contact plug CB, which is integrally formed with the gate line 160, and the via contact VA, which is integrally formed with the source/drain contact CA, to increase the degree of integration of the integrated circuit device 100. By integrally forming the gate contact plug CB, which is connected to the upper wiring layer M1, with the gate line 160, and integrally forming the via contact VA, which is connected to the upper wiring layer M1, with the source/drain contact CA, misalignments and poor connections (for example, short circuits) between wires may be prevented, and the electrical performance of the integrated circuit device 100 may be increased.

In addition, the integrated circuit device 100 of the present inventive concept may include the first spacer 154 and the second spacer 156 with different etching selectivities from each other, and thus, the via rail VAR may be arranged in contact with the via contact VA and the via contact extension portion VAE. In this case, because the via rail VAR includes the same material as the via contact VA, an interface might not be formed between the via rail VAR and the via contact VA. Because a separate barrier metal layer is not formed between the via rail VAR and the via contact VA, resistance of the via rail VAR and the via contact VA may be reduced, and thus electrical characteristics of the integrated circuit device 100 may be improved.

The upper surface of each of the first spacer 154, the second spacer 156, the gate contact plug extension portion CBE, and the via contact extension portion VAE may be covered with an etching stop layer 185 and an interlayer insulating layer 187. The etching stop layer 185 may include silicon carbide (SiC), SiN, SiCN, SiOC, AlN, AlON, AlO, AlOC, or a combination thereof. The interlayer insulating layer 187 may include an oxide layer, a nitride layer, an ultra low k (ULK) layer having an ultra low dielectric constant K of about 2.2 to about 2.4, or a combination thereof. For example, the interlayer insulating layer 187 may include a tetra-ethyl-ortho-silicate (TEOS) layer, a high density plasma (HDP) layer, a boro-phosphosilicate glass (BPSG) layer, a flowable chemical vapor deposition (FCVD) oxide layer, an SiON layer, an SiOC layer, an SiCOH layer, or a combination thereof, but the present inventive concept is not limited thereto.

A plurality of upper wiring layers M1 penetrating the etching stop layer 185 and the interlayer insulating layer 187 may be arranged on the substrate 102. The plurality of upper wiring layers M1 may extend lengthwise in the first horizontal direction (X direction). In this case, the vertical level of the plurality of upper wiring layers M1 may be higher than vertical levels of the via contact extension portion VAE and the gate contact plug extension portion CBE. The plurality of upper wiring layers M1 may include the upper wiring layer M1 connected to the via contact VA, and the upper wiring layer M1 connected to the gate contact plug CB. The upper wiring layer M1 may be connected to the via contact extension portion VAE and the gate contact plug extension portion CBE. The plurality of upper wiring layers M1 may include, for example, Mo, Cu, W, Co, Ru, Mn, Ti, Ta, Al, a combination thereof, or an alloy thereof, but the present inventive concept is not limited thereto.

A power wiring layer MPW penetrating the etching stop layer 185 and the interlayer insulating layer 187 may be arranged on the substrate 102. The power wiring layer MPW may extend lengthwise in the first horizontal direction (X direction). In this case, a vertical level of the power wiring layer MPW may be higher than vertical levels of the via contact extension portion VAE and the via rail VAR. An upper surface of the power wiring layer MPW be substantially coplanar with an upper of the interlayer insulating layer 187 and an upper surface of the upper wiring layer M1. The power wiring layer MPW may be connected to the via contact VA and the via rail VAR. The power wiring layer MPW may be simultaneously connected to the via contact VA and the via rail VAR. The power wiring layer MPW may be simultaneously connected to the via contact extension portion VAE and the via rail VAR. A width of the power wiring layer MPW in the second horizontal direction (Y direction) may be substantially equal to a sum of widths of the via contact VA and the via rail VAR in the second horizontal direction (Y direction). However, the present inventive concept is not limited thereto. For example, the width of the power wiring layer MPW in the second horizontal direction (Y direction) may be greater than or less than the sum of widths of the via contact VA and the via rail VAR in the second horizontal direction (Y direction). The power wiring layer MPW may include, for example, Mo, Cu, W, Co, Ru, Mn, Ti, Ta, Al, a combination thereof, or an alloy thereof, but the present inventive concept is not limited thereto.

FIGS. 3A through 9D are cross-sectional views for describing a manufacturing method of an integrated circuit device, according to embodiments of the present inventive concept. FIGS. 3A, 4A, 5A, 6A, 7A, 8A, and 9A are cross-sectional views of a portion corresponding to cross-sectional view taken along line X1-X1' in FIG. 1 according to a process sequence. FIGS. 3B, 4B, 5B, 6B, 7B, 8B, and 9B are cross-sectional views of a portion corresponding to a cross-sectional view taken along line X2-X2' in FIG. 1 according to a process sequence. FIGS. 3C, 4C, 5C, 6C, 7C, 8C, and 9C are cross-sectional views of a portion corresponding to a cross-sectional view taken along line Y1-Y1' in FIG. 1 according to a process sequence. FIGS. 3D, 4D, 5D, 6D, 7D, 8D, and 9D are cross-sectional views of a portion corresponding to a cross-sectional view taken along line Y2-Y2' in FIG. 1 according to a process sequence.

Referring to FIGS. 3A through 3D, the plurality of nanosheet stacks NSS and the plurality of source/drain areas 130 may be formed on the substrate 102 having the plurality of fin-type active areas F 1. In addition, the plurality of gate lines 160 and the plurality of source/drain contacts CA may be formed on the substrate 102.

By alternately stacking a plurality of sacrificial semiconductor layers and a plurality of nanosheet semiconductor layers one by one on the substrate 102, and etching portions of the plurality of sacrificial semiconductor layers, the plurality of nanosheet semiconductor layers, and the substrate 102, the plurality of fin-type active areas F1 protruding from the substrate 102 may be formed. In this case, the plurality of sacrificial semiconductor layers and the plurality of nanosheet semiconductor layers may include semiconductor materials having different etching selectivities from each other. For example, the plurality of nanosheet semiconductor layers may include Si layers, and the plurality of sacrificial semiconductor layers may include SiGe layers. The device separation layer 112 covering a sidewall of each of the plurality of fin-type active areas F1 may be formed on the substrate 102.

Thereafter, the plurality of insulating spacers 118 covering a plurality of dummy gate structures, that are on a stacked structure of the plurality of sacrificial semiconductor layers and the plurality of nanosheet semiconductor layers, and sidewalls of each of the plurality of dummy gate structures may be formed. By using the plurality of dummy gate structures and the plurality of insulating spacers 118 as etching masks to etch a portion of each of the plurality of sacrificial semiconductor layers and the plurality of nanosheet semiconductor layers, and a portion of the fin-type active area F1, the plurality of nanosheet semiconductor layers may be divided into the plurality of nanosheet stacks NSS, and the plurality of recesses RC may be formed on the fin-type active area F1. Each of the plurality of nanosheet stacks NSS may include the first nanosheet N1, the second nanosheet N2, and the third nanosheet N3. To form the plurality of recesses RC, an etching process may be performed by using, for example, a dry etching process, a wet etching process, or a combination thereof.

Thereafter, the plurality of source/drain areas 130 respectively filling the plurality of recesses RC may be formed. To form the plurality of source/drain areas 130, a semiconductor material may be epitaxially grown from a surface of the fin-type active area F1, which forms the lower surface of the plurality of recesses RC, and the sidewalls of each of the first nanosheet N1, the second nanosheet N2, and the third nanosheet N3, which are included in the nanosheet stack NSS. The insulating liner 142 covering the plurality of source/drain areas 130 may be formed on the plurality of source/drain areas 130, and the inter-gate insulating layer 144 may be formed on the insulating liner 142.

Thereafter, the dummy gate structure may be removed to provide a gate space, and the plurality of nanosheet stacks NSS may be exposed through the gate space. Thereafter, by removing the plurality of sacrificial semiconductor layers that remain on the fin-type active area F1 through the gate space, the gate space may be extended to a space between each of the first nanosheet N1, the second nanosheet N2, and the third nanosheet N3, and a space between the first nanosheet N1 and the fin upper surface FT. In embodiments of the present inventive concept, to selectively remove the plurality of sacrificial semiconductor layers, a difference in etching selectivity between the first nanosheet N1, the second nanosheet N2, and the third nanosheet N3, and the plurality of sacrificial semiconductor layers may be used. An etchant in a liquid or gaseous state may be used to selectively remove the plurality of sacrificial semiconductor layers. For example, to selectively remove the plurality of sacrificial semiconductor layers, a CH₃COOH-based etchant, such as an etchant solution containing a mixture of CH₃COOH, HNO₃, and HF, and an etchant solution containing a mixture of CH₃COOH, H₂O₂, and HF, may be used, but the present inventive concept is not limited thereto.

Thereafter, the gate dielectric layer 152 covering the exposed surface of each of the first nanosheet N1, the second nanosheet N2, and the third nanosheet N3, and the fin-type active area F1 may be formed. An atomic layer deposition (ALD) process may be used for forming the gate dielectric layer 152. The gate line 160 may be formed on the gate dielectric layer 152.

Thereafter, a plurality of source/drain contact holes penetrating the insulating structure including the insulating liner 142 and the inter-gate insulating layer 144 and exposing the source/drain area 130 may be formed. In addition, a portion of the source/drain area 130 may be removed by using an anisotropic etching process through each of the plurality of source/drain contact holes, and a metal silicide layer 172 may be formed on the source/drain area 130 that is exposed at a bottom side of each of the plurality of source/drain contact holes. Thereafter, a plurality of source/drain contacts CA extending in the second horizontal direction (Y direction) may be formed by providing the conductive barrier layer 174 and the contact plug 176 inside each of the plurality of source/drain contact holes.

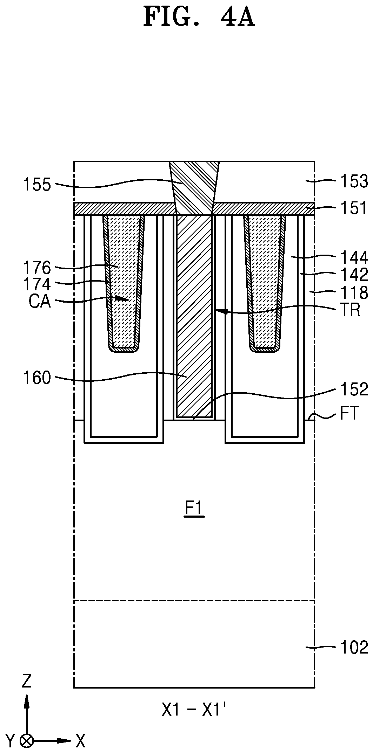

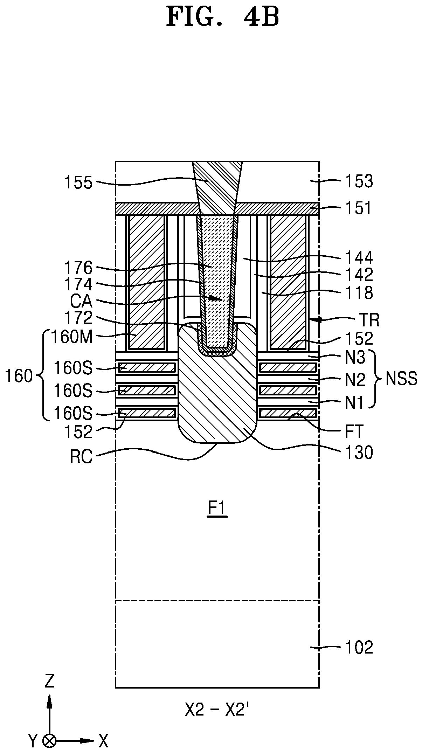

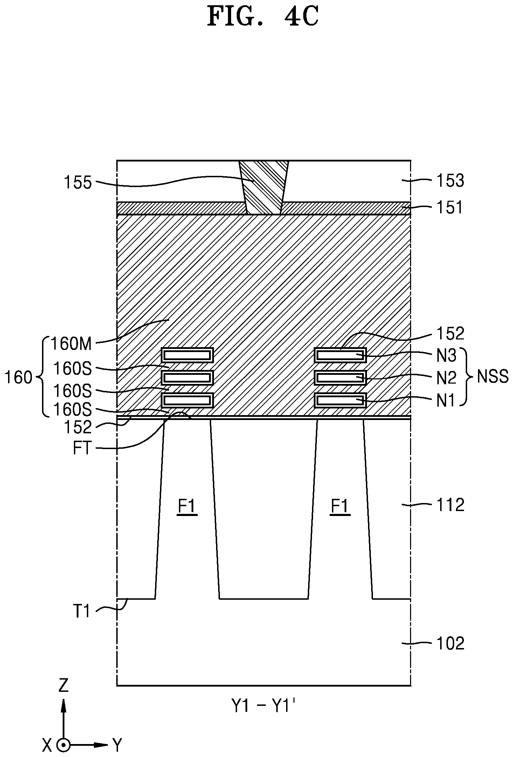

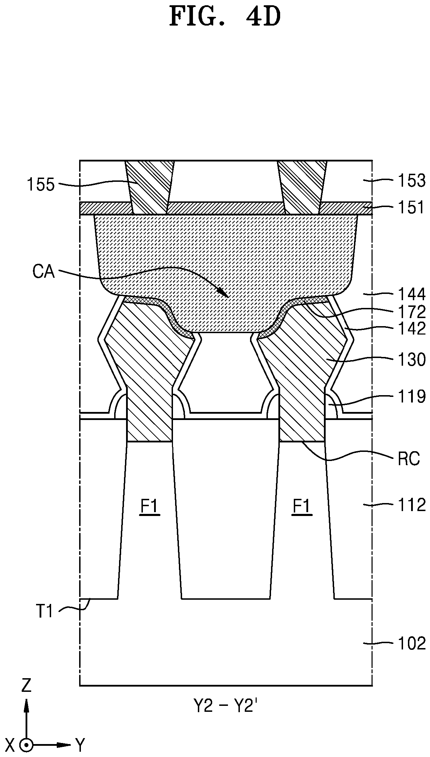

Referring to FIGS. 4A through 4D, a first insulating layer 151 and a second insulating layer 153 may be sequentially formed on the substrate 102. The first insulating layer 151 and the second insulating layer 153 may be formed to cover the gate line 160 and the source/drain contact CA. For example, the first insulating layer 151 may include silicon nitride, and the second insulating layer 153 may include a carbon-based material such as spin-on hardmask (SOH), but the present inventive concept is not limited thereto. Thereafter, a plurality of pillars 155 penetrating the first insulating layer 151 and the second insulating layer 153 may be formed. The plurality of pillars 155 may be arranged on the plurality of gate lines 160 and the plurality of source/drain contacts CA. The plurality of pillars 155 may be arranged to be spaced apart from each other by a certain interval in the first horizontal direction (X direction) and/or the second horizontal direction (Y direction). In this case, the pillar 155 may include silicon oxide.

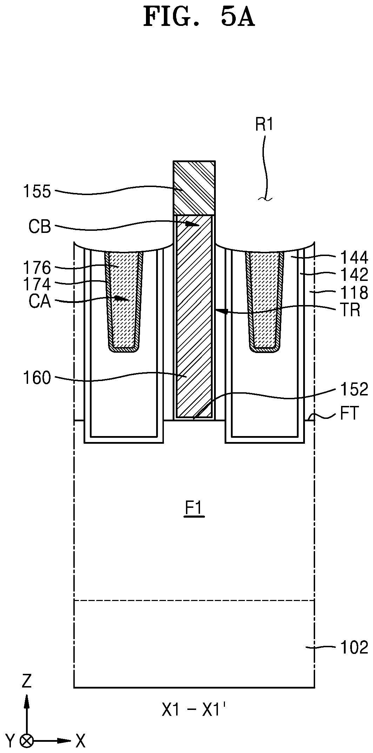

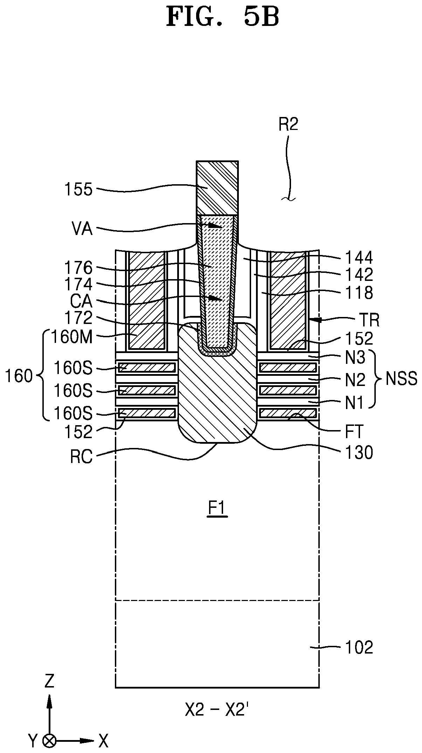

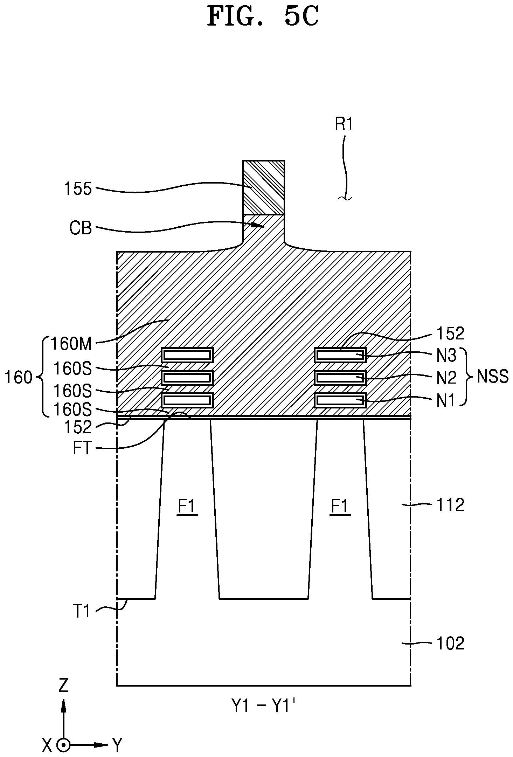

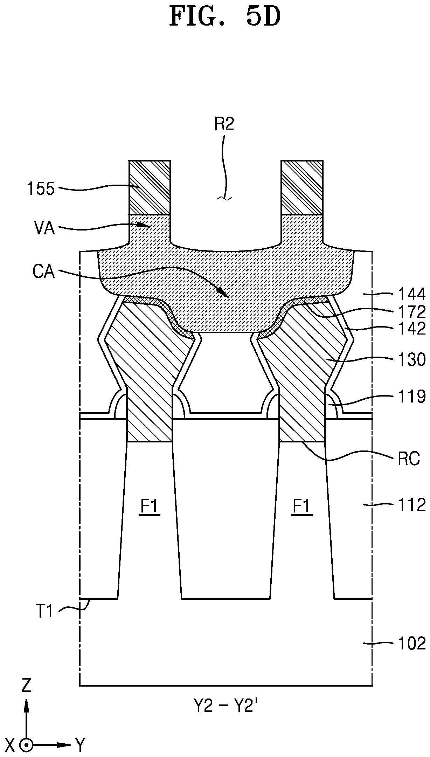

Referring to FIGS. 5A through 5D, a first recess R1 and a second recess R2 may be formed by removing a portion of the pillar 155, the first insulating layer 151, and the second insulating layer 153. The first recess R1 may be formed by removing a portion of an upper end of the gate line 160. In addition, upper portions of the inter-gate insulating layer 144, the insulating liner 142, and the insulating spacers 118 may be removed. A portion of the upper end of the gate line 160 may be removed to form a gate contact plug CB protruding from the upper surface of the gate line 160 in the vertical direction (Z direction). The gate contact plug CB may be integrally formed with the gate line 160.

The second recess R2 may be formed by removing a portion of an upper end of the source/drain contact CA. A portion of the upper end of the source/drain contact CA may be removed to form the via contact VA protruding from the upper surface of the source/drain contact CA in the vertical direction (Z direction). The via contact VA may be integrally formed with the source/drain contact CA.

In this case, the upper surface of the gate contact plug CB and the upper surface of the via contact VA may be formed to be substantially coplanar with each other. For example, a height of the gate contact plug CB and the via contact VA in the vertical direction (Z direction) may be within about 15 nm.

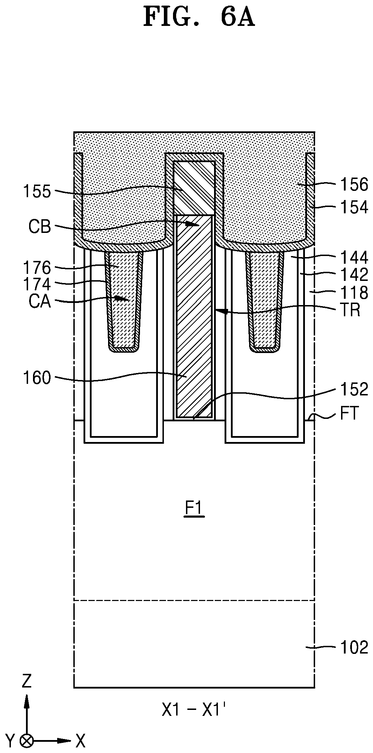

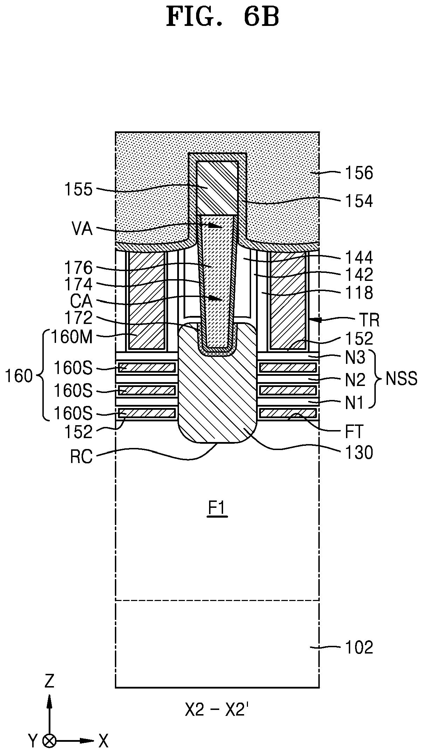

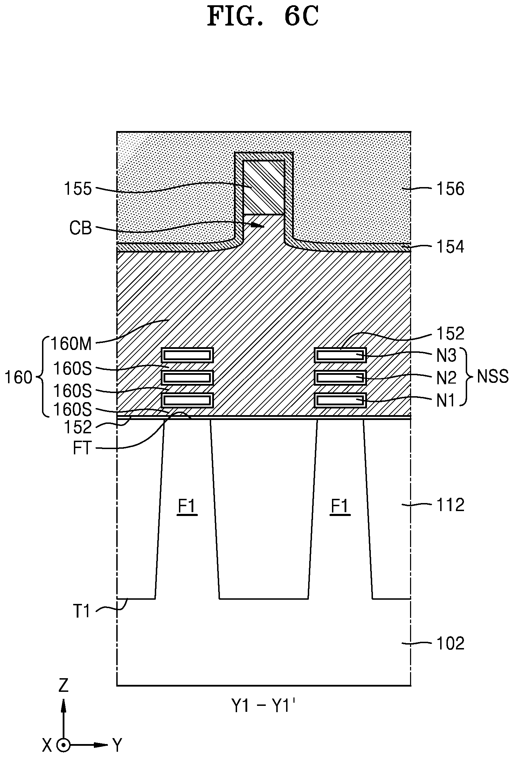

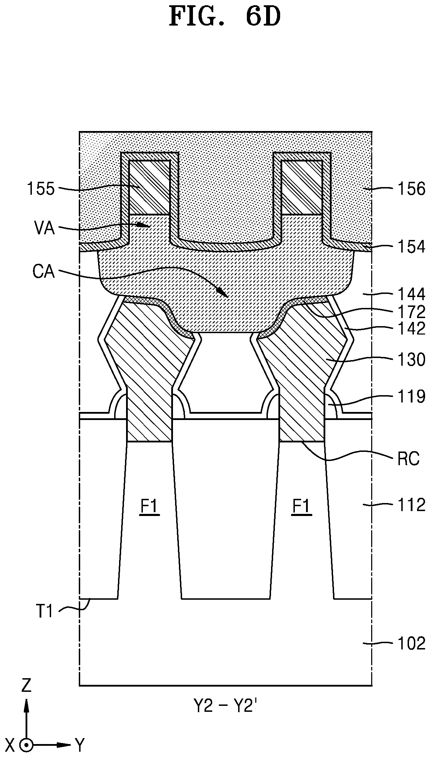

Referring to FIGS. 6A through 6D, the first spacer 154 and the second spacer 156 may be sequentially formed on the substrate 102. The first spacer 154 may be formed to cover the gate line 160 and the source/drain contact CA. In addition, the first spacer 154 may be formed to cover the sidewalls of the gate contact plug CB and the via contact VA. In addition, the first spacer 154 may be formed to cover an upper surface and sidewalls of the pillar 155. The first spacer 154 may conformally cover the gate line 160, the source/drain contact CA, the gate contact plug CB, the via contact VA, and the pillar 155. In this case, the first spacer 154 may have a thickness of about 10 nm. The second spacer 156 may be formed on the first spacer 154. The second spacer 156 may conformally cover the first spacer 154. In this case, the thickness of the second spacer 156 may be about 20 nm. The second spacer 156 may include a material having an etching selectivity different from an etching selectivity of the first spacer 154. In embodiments of the present inventive concept, the first spacer 154 may include an SiOC material, and the second spacer 156 may include silicon nitride.

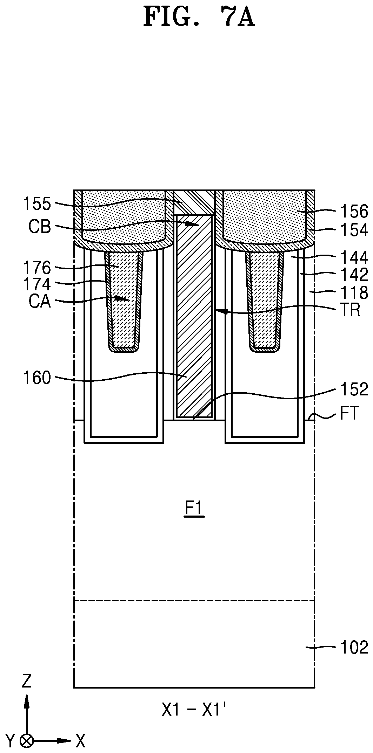

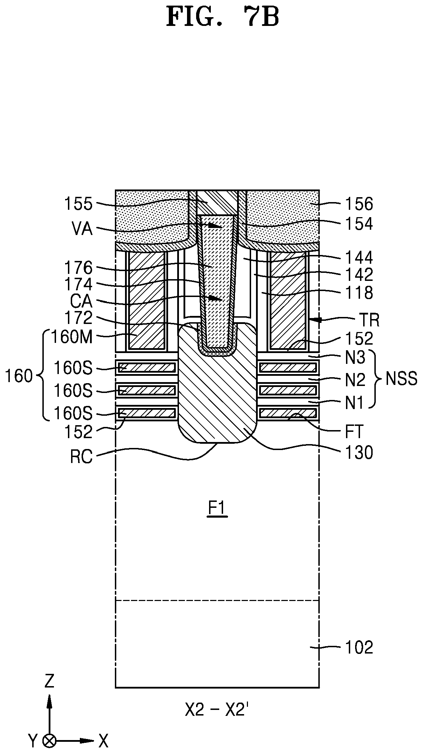

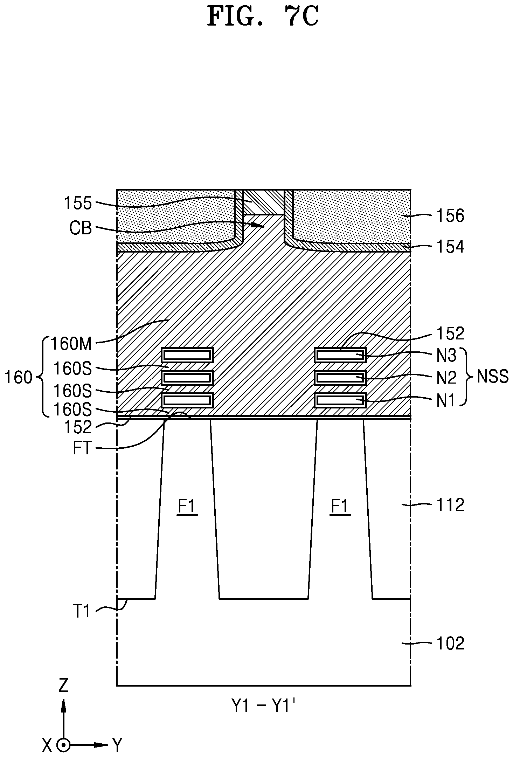

Referring to FIGS. 7A through 7D, a portion of the first spacer 154, a part of the second spacer 156, and a portion of the pillar 155 may be removed by using a chemical mechanical polishing (CMP) process. In this case, upper surfaces of the first spacer 154, the second spacer 156, and the pillar 155 may form a coplanar flat surface by using the planarization process, and the height of the pillar 155 in the vertical direction (Z direction) may be about 10 nm.

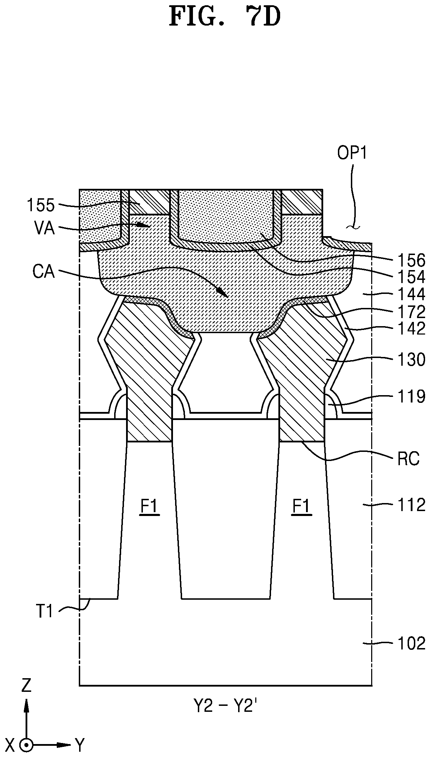

Thereafter, referring to FIG. 7D, a via rail cut OP1 may be formed by removing a portion of the first spacer 154 and a portion of the second spacer 156. The via rail cut OP1 may extend lengthwise in the first horizontal direction (X direction). For example, the portion of the first spacer 154 that extends along a sidewall of a pillar 155 and a sidewall of the source/drain contact CA may be removed. In this case, the via rail cut OP1 may expose the sidewall of the via contact VA and the sidewall of the pillar 155. In addition, the via rail cut OP1 may expose the remaining portion of the first spacer 154. Because etching selectivities of the first spacer 154 and the second spacer 156 are different in the process of forming the via rail cut OP1, the second spacer 156 may be removed, and a portion of the first spacer 154 may remain and be exposed.

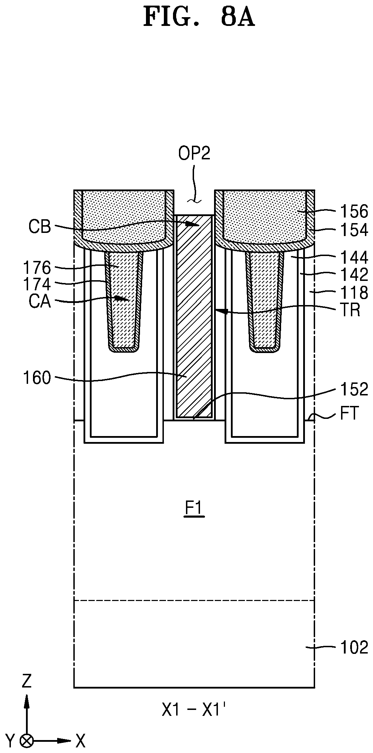

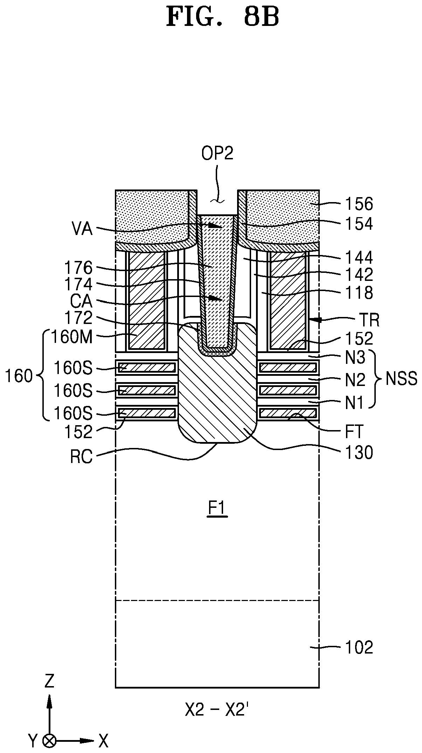

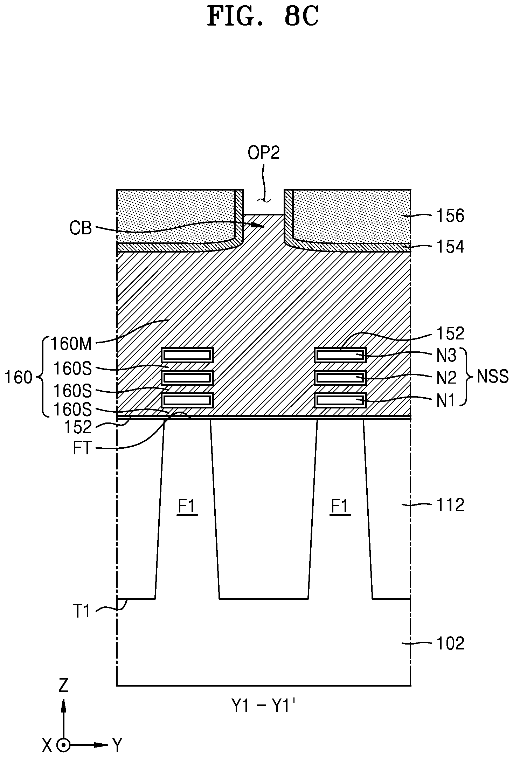

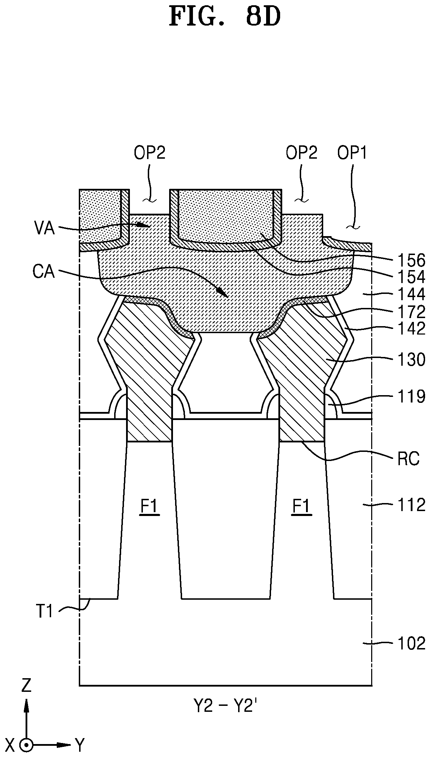

Referring to FIGS. 8A through 8D, the plurality of pillars 155 may be removed to form a plurality of openings OP2. The plurality of pillars 155 may be removed by using a cleaning process. By removing the plurality of pillars 155, the upper surface of the gate contact plug CB and the upper surface of the via contact VA may be exposed.

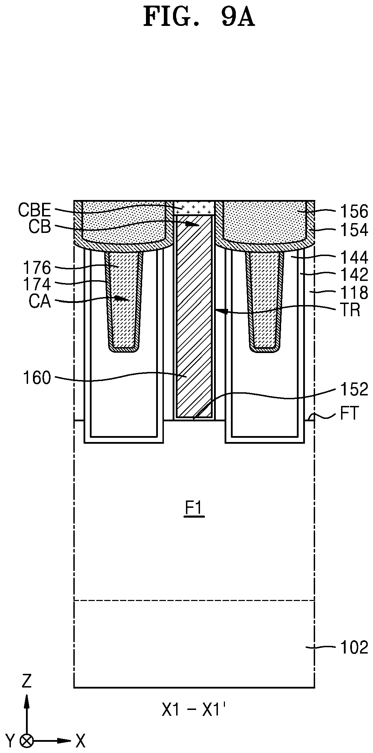

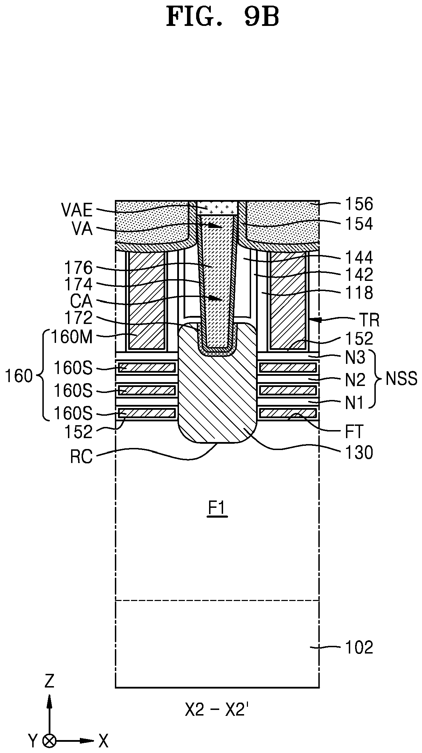

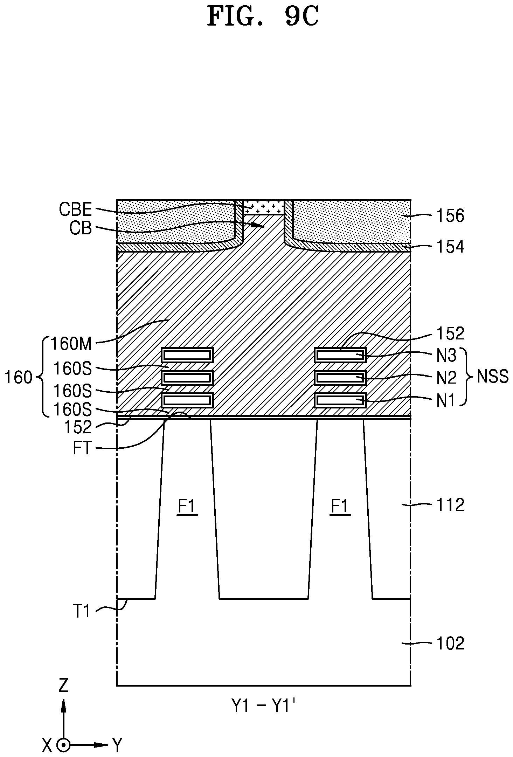

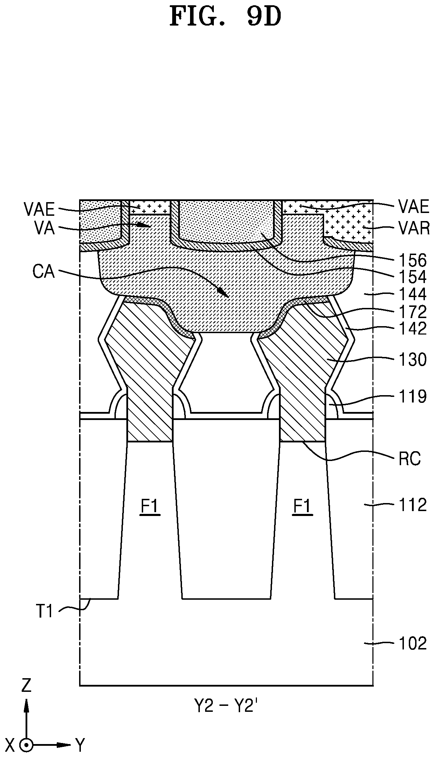

Referring to FIGS. 9A through 9D, a conductive layer filling the via rail cut OP1 and the plurality of openings OP2 may be formed. The conductive layer may fill the via rail cut OP1 and the plurality of openings OP2, and may cover an upper surface of the first spacer 154 and an upper surface of the second spacer 156. The conductive layer may include the same material as the source/drain contact CA. For example, the conductive layer may include a metal of molybdenum (Mo), copper (Cu), tungsten (W), cobalt (Co), ruthenium (Ru), manganese (Mn), titanium (Ti), tantalum (Ta), aluminum (Al), or a combination thereof. In this case, the conductive layer may grow upward from a lower portion of the via rail cut OP1 and the plurality of openings OP2.

Thereafter, by applying a planarization process to remove a portion of the first spacer 154, a portion of the second spacer 156, and a portion of the conductive layer, the via rail VAR, the via contact extension portion VAE, and the gate contact plug extension portion CBE may be formed.

The via rail VAR may be formed in the via rail cut OP1. The via rail VAR may be arranged to be in contact with the via contact VA and the via contact extension portion VAE. One of the sidewalls of the via rail VAR in the second horizontal direction (Y direction) may be in contact with the sidewall of the via contact VA. In addition, the via rail VAR and the via contact extension portion VAE may be arranged to partially overlap each other in the second horizontal direction (Y direction).

In addition, the via contact extension portion VAE and the gate contact plug extension portion CBE may be formed in the plurality of openings OP2. In this case, the via rail VAR, the via contact extension portion VAE, and the gate contact plug extension portion CBE may include the same material. For example, the via rail VAR and the via contact extension portion VAE may be integrally formed with each other. Because the via rail VAR includes the same material as the via contact VA, an interface might not be formed between the via rail VAR and the via contact VA. Because a separate barrier metal layer is not formed between the via rail VAR and the via contact VA, resistance of the via rail VAR and the via contact VA may be reduced, and thus, electrical characteristics of the integrated circuit device 100 may be improved.

The upper surface of each of the first spacer 154, the second spacer 156, the via rail VAR, the via contact extension portion VAE, and the gate contact plug extension portion CBE may be substantially coplanar. In this case, the gate contact plug extension portion CBE and the via contact extension portion VAE may have a thickness of about 5 nm in the vertical direction (Z direction).

Thereafter, as illustrated in FIGS. 2A through 2D, the etching stop layer 185 and the interlayer insulating layer 187, which cover the upper surface of the first spacer 154, the upper surface of the second spacer 156, the upper surface of the via rail VAR, the upper surface of the via contact extension portion VAE, and the upper surface of the gate contact plug extension portion CBE, may be formed, and by forming the upper wiring layer M1 and the power wiring layer MPW such that they both penetrate the etching stop layer 185 and the interlayer insulating layer 187, the integrated circuit device 100 may be manufactured.

## Claims

1. An integrated circuit device (100) comprising:
a fin-type active area (F1) extending in a first horizontal direction (X) on a substrate (102);
a gate line (160) extending in a second horizontal direction (Y) crossing the first horizontal direction (X) on the fin-type active area (F1) and the substrate (102);
a source/drain area (130) arranged on the fin-type active area (F1);
a gate dielectric layer (152) disposed on a lower surface and sidewalls of the gate line (160);
a source/drain contact (CA) arranged on the source/drain area (130) to be in contact with the source/drain area (130);
a via contact (VA) integrally connected to the source/drain contact (CA) and protruding in a vertical direction (Z);
a gate contact plug (CB) integrally connected to the gate line (160) and protruding in the vertical direction (Z);
a first wiring layer (M1) electrically connected to the via contact (VA) and the gate contact plug (CB), and extending in the first horizontal direction (X); and
a via rail (VAR) connected to the first wiring layer (M1), and extending in the first horizontal direction (X) at a vertical level that is lower than a vertical level of the first wiring layer (M1).

2. The device (100) of claim 1, wherein the via rail (VAR) is in contact with a sidewall of the via contact (VA).

3. The device (100) of claim 1 or 2, further comprising:
a via contact extension portion (VAE) arranged between the first wiring layer (M1) and the via contact (VA); and
a gate contact plug extension portion (CBE) arranged between the first wiring layer (M1) and the gate contact plug (CB).

4. The device (100) of claim 3, wherein the via rail (VAR), the via contact extension portion (VAE), and the gate contact plug extension portion (CBE) comprise an identical material to the source/drain contact (CA).

5. The device (100) of claim 3 or 4, wherein upper surfaces of the via rail (VAR), the via contact extension portion (VAE), and the gate contact plug extension portion (CBE) are coplanar.

6. The device (100) of any one of claims 3 to 5, wherein the via rail (VAR) overlaps the via contact extension portion (VAE) in the second horizontal direction (Y).

7. The device (100) of any one of claims 3 to 6, wherein the via rail (VAR) and the via contact extension portion (VAE) are integrally formed.

8. The device (100) of any one of claims 3 to 7, wherein thicknesses in the vertical direction (Z) of the via contact extension portion (VAE) and the gate contact plug extension portion (CBE) are about 5 nm or less.

9. The device (100) of any one of claims 1 to 8, further comprising:
a first spacer (154) configured to conformally cover an upper surface of the gate line (160), an upper surface of the source/drain contact (CA), sidewalls of the gate contact plug (CB), and sidewalls of the via contact (VA); and
a second spacer (156) configured to cover the first spacer (154).

10. The device (100) of claim 9, wherein the first spacer (154) and the second spacer (156) include materials of different etching selectivities.

11. The device (100) of any one of claims 1 to 10, further comprising:
a second wiring layer simultaneously connected to the via rail (VAR) and the via contact (VA).

12. An integrated circuit device (100) comprising:
a fin-type active area (F1) extending in a first horizontal direction (X) on a substrate (102);
a gate line (160) extending in a second horizontal direction (Y) crossing the first horizontal direction (X) on the fin-type active area (F1) and the substrate (102);
a source/drain area (130) arranged on the fin-type active area (F1);
a gate dielectric layer (152) disposed on a lower surface and sidewalls of the gate line (160);
a source/drain contact (CA) arranged on the source/drain area (130) to be in contact with the source/drain area (130);
a via contact (VA) integrally connected to the source/drain contact (CA) and configured to protrude in a vertical direction (Z);
a gate contact plug (CB) integrally connected to the gate line (160) and protruding in the vertical direction (Z);
a first wiring layer (M1) electrically connected to the via contact (VA) and the gate contact plug (CB), and extending in the first horizontal direction (X); and
a via rail (VAR) extending in the first horizontal direction (X) and in contact with the first wiring layer (M1), wherein the via rail (VAR) is in contact with sidewalls of the via contact (VA).

13. An integrated circuit device (100) comprising:
a fin-type active area (F1) extending in a first horizontal direction (X) on a substrate (102);
a gate line (160) extending in a second horizontal direction (Y) crossing the first horizontal direction (X) on the fin-type active area (F1) and the substrate (102);
a source/drain area (130) arranged on the fin-type active area (F1);
a gate dielectric layer (152) disposed on a lower surface and sidewalls of the gate line (160);
a source/drain contact (CA) arranged on the source/drain area (130) to be in contact with the source/drain area (130);
a via contact (VA) integrally connected to the source/drain contact (CA) and protruding in a vertical direction (Z);
a gate contact plug (CB) integrally connected to the gate line (160) and protruding in the vertical direction (Z);
a first wiring layer (M1) electrically connected to the via contact (VA) and the gate contact plug (CB), and extending in the first horizontal direction (X);
a via contact extension portion (VAE) arranged between the first wiring layer (M1) and the via contact (VA);
a gate contact plug extension portion (CBE) arranged between the first wiring layer (M1) and the gate contact plug (CB);
a first spacer (154) configured to conformally cover an upper surface of the gate line (160), an upper surface of the source/drain contact (CA), sidewalls of the gate contact plug (CB), and sidewalls of the via contact (VA);
a second spacer (156) configured to cover the first spacer (154), and comprising a material of different etching selectivity from the first spacer (154); and
a via rail (VAR) extending in the first horizontal direction (X) and in contact with the first wiring layer (M1), wherein the via rail (VAR) is in contact with sidewalls of the via contact (VA) and sidewalls of the via contact extension portion (VAE).

14. The device (100) of claim 13, wherein each of the via rail (VAR), the via contact extension portion (VAE), and the gate contact plug extension portion (CBE) comprises an identical material to the source/drain contact (CA).

15. The device (100) of claim 13 or 14, wherein the via rail (VAR) and the via contact extension portion (VAE) are integrally formed.
